# FASCICULE DE BREVET EUROPEEN

(11) **EP 3 266 738 B1**
(45) Date de publication et mention de la délivrance du brevet: **06.03.2019**
(21) Numéro de dépôt: 16178118.2
(22) Date de dépôt: 06.07.2016
(51) Int. Cl.: B81C 99/00, C25D 1/00, G04B 19/04

(54) **PROCÉDÉ DE FABRICATION D'UNE PIÈCE D'HORLOGERIE DOTÉE D'UN ÉLÉMENT D'HABILLAGE MULTI-NIVEAUX**
HERSTELLUNGSVERFAHREN FÜR EIN UHRENBAUTEIL, DAS MIT EINER MEHRSTUFIGEN HABILLAGE AUSGESTATTET IST
METHOD FOR MANUFACTURING A PART FOR A TIMEPIECE PROVIDED WITH A MULTI-LEVEL EXTERIOR ELEMENT

(43) Date de publication de la demande: 10.01.2018
(73) Titulaire: The Swatch Group Research and Development Ltd., 2074 Marin (CH)
(72) Inventeur: Vuille, Pierry, 2338 Les Emibois (CH); Mosteiro Vazquez, Yoann, 2016 Cortaillod (CH); Grossenbacher, Pascal, 2000 Neuchâtel (CH)
(74) Mandataire: Goulette, Ludivine

(56) Documents cités:
- EP-A1- 2 229 470
- EP-A1- 3 035 128
- CH-A2- 708 827
- US-A- 5 242 711

## Description

### Domaine de l'invention

L'invention se rapporte à un procédé de fabrication d'une pièce telle qu'une pièce d'horlogerie, de joaillerie ou de bijouterie, par exemple un cadran de montre, une lunette, une couronne, un maillon de bracelet, un fermoir, etc., ou encore une pièce d'outillage telle qu'un outil de frappe, un moule, etc. Le procédé permet plus particulièrement de réaliser une pièce comprenant un corps de pièce et un élément d'habillage multi-niveaux en relief sur le corps de la pièce, l'élément d'habillage étant tel qu'un indicateur des heures, un élément décoratif, une lettre, etc. Par multi-niveaux, on entend que l'élément comporte au moins deux faces planes visibles qui s'étendent parallèlement l'une à l'autre et parallèlement au corps de la pièce.

### Arrière-plan de l'invention

Dans le domaine de l'horlogerie, la joaillerie ou la bijouterie, il est classique de réaliser des éléments d'habillage multi-niveaux par des techniques de photolithographie et de dépôt galvanique. Le document EP 2 316 056 B1 décrit notamment un procédé de fabrication d'un élément métallique ou en alliage métallique multi-niveaux, utilisant la technique LIGA-UV. Ce procédé comprend les étapes suivantes, dans cet ordre :
- se munir d'un substrat comportant une surface conductrice
- recouvrir la surface conductrice du substrat d'une première couche de résine photosensible
- irradier la première couche de résine photosensible à travers un masque correspondant à une empreinte désirée
- développer la première couche de résine photosensible de manière à creuser dans celle-ci des ouvertures et à obtenir ainsi un premier niveau d'un moule en résine, les ouvertures dans la première couche de résine laissant apparaître la surface conductrice du substrat
- déposer une nouvelle couche de résine photosensible sur la couche de résine développée, de manière à recouvrir cette dernière et, de préférence, à remplir les ouvertures dans celle-ci
- irradier la nouvelle couche de résine photosensible à travers un masque correspondant à l'empreinte désirée
- développer la nouvelle couche de résine photosensible de manière à creuser dans celle-ci des ouvertures et à obtenir un moule en résine multi-niveaux, les ouvertures dans le moule multi-niveaux laissant apparaître la surface conductrice du substrat
- remplir les ouvertures du moule en résine multi-niveaux d'un métal ou d'un alliage, par dépôt galvanique
- éliminer les couches de résine de manière à faire apparaître un élément métallique ou d'alliage multi-niveaux constitué par ledit métal ou alliage déposé dans les ouvertures.

Les éléments multi-niveaux ainsi fabriqués sont ensuite séparés du substrat et implantés sur un corps de pièce d'horlogerie, de joaillerie ou de bijouterie.

Ce procédé de fabrication de pièces dotées d'éléments d'habillage multi-niveaux présente l'inconvénient d'être long à mettre en oeuvre, notamment à cause de la nécessité de remplir intégralement les ouvertures du moule lors du dépôt galvanique. Un deuxième inconvénient est la nécessité d'un assemblage des éléments d'habillage sur le corps de pièce, d'où des risques de désolidarisation en cas de chocs, par exemple.

### Résumé de l'invention

La présente invention vise à pallier en tout ou en partie les inconvénients évoqués précédemment.

A cet effet, l'invention se rapporte à un procédé de fabrication d'une pièce dotée d'un élément d'habillage, comportant les étapes suivantes :
- Superposer une couche électriquement isolante comportant un premier orifice traversant, une couche supplémentaire comportant une première ouverture traversante de dimensions similaires au premier orifice, une couche intermédiaire comprenant un premier trou traversant, et une couche de base surmontée d'un motif de base, de sorte à placer le motif de base dans le premier trou, recouvrir le premier trou par la première ouverture, et superposer la première ouverture et le premier orifice
- Déposer galvaniquement une couche métallique ou d'alliage métallique, de sorte qu'à l'issue de cette étape, la couche métallique ou d'alliage métallique forme une coque recouvrant des parois électriquement conductrices du motif de base, du premier orifice, de la première ouverture et du premier trou, et comporte une zone latérale reposant sur la couche isolante
- Dissoudre la couche isolante
- Recouvrir la couche métallique ou d'alliage métallique d'un volume constitué au moins en partie par un matériau de base de la pièce, de sorte que le volume épouse les formes de la couche métallique ou d'alliage métallique
- Extraire le volume et la couche métallique ou d'alliage métallique.

Le procédé permet de fabriquer simultanément le corps de la pièce (constitué par le volume de matériau de base de la pièce) et l'élément d'habillage (constitué par la couche métallique ou d'alliage). L'élément d'habillage est directement fixé au corps de pièce, sans qu'il y ait besoin d'une étape d'assemblage. En effet, la zone latérale de la couche métallique ou d'alliage reposant sur la couche isolante à l'issue de la phase de dépôt, se retrouve scellée dans le volume à l'issue de la phase de recouvrement.

De plus, le procédé est plus rapide à mettre en oeuvre que le procédé de l'art antérieur précédemment décrit. En effet, la durée du dépôt galvanique est plus courte, car la couche métallique ou d'alliage n'a pas à remplir les orifices, ouvertures et trous (formant un moule), mais doit simplement recouvrir leurs parois ainsi que le motif. En d'autres termes, la structure métallique ou en alliage métallique n'est pas massive, elle forme au contraire une coque creuse. L'épaisseur à déposer par galvanoplastie est donc plus faible.

Les interfaces entre le corps de pièce et l'élément d'habillage sont nettes, sans bavure. De plus, en choisissant des formes et dimensions appropriées pour les différents motifs, ouvertures, orifices ou trous intervenant dans les procédés de fabrication, il est possible de réaliser des éléments d'habillage de formes et de dimensions variées. En outre, une texture se trouvant sur la couche supplémentaire se retrouve gravée par effet d'empreinte sur le corps de pièce (le volume de matériau de base de la pièce).

En outre, le procédé de fabrication peut comprendre une ou plusieurs des caractéristiques ci-dessous, prises indépendamment ou selon toutes les combinaisons techniquement possibles.

Selon un mode de réalisation non limitatif, le procédé comporte une étape de formation de surfaces électriquement conductrices sur les parois du motif de base, du premier orifice, de la première ouverture et/ou du premier trou, par exemple par une technique de dépôt physique par phase vapeur.

Selon un mode de réalisation non limitatif, le procédé comporte une étape de formation d'une surface électriquement conductrice sur une portion d'une face supérieure de la couche isolante située en périphérie du premier orifice.

Selon un mode de réalisation non limitatif, le procédé comprend une étape de formation du motif de base sur la couche de base, comportant une application, une irradiation et un développement d'une résine photosensible, par exemple une résine SU8.

Selon un mode de réalisation non limitatif, le procédé comprend une étape de formation de la couche de base à partir d'un wafer en silicium, comportant un revêtement dudit wafer par un film conducteur.

Selon un mode de réalisation non limitatif, le procédé comporte une étape de formation de surfaces électriquement conductrices sur les parois du motif intermédiaire, du deuxième orifice et/ou de la deuxième ouverture.

Selon un mode de réalisation non limitatif, le procédé comporte une étape de formation d'une surface électriquement conductrice sur une portion d'une face supérieure de la couche isolante située en périphérie du deuxième orifice.

Selon un mode de réalisation non limitatif, le procédé comporte une étape de formation du motif intermédiaire sur la couche intermédiaire, comportant une application, une irradiation et un développement d'une résine photosensible, par exemple une résine SU8.

Selon un mode de réalisation non limitatif, le procédé comporte une étape de formation de la couche intermédiaire comportant une découpe, par exemple au laser, d'une plaque, par exemple en laiton.

Selon un mode de réalisation non limitatif, le procédé comporte une étape de formation de la couche supplémentaire comportant une découpe, par exemple au laser, d'une plaque, par exemple en laiton.

Selon un mode de réalisation non limitatif, l'étape de formation de la couche supplémentaire comprend un estampillage de la couche supplémentaire de sorte à y former un motif supplémentaire, la couche électriquement isolante comportant un orifice supplémentaire, l'orifice supplémentaire étant placé en regard du motif supplémentaire lorsque le couche isolante et la couche supplémentaire sont superposées.

Selon un mode de réalisation non limitatif, l'étape de formation de la couche supplémentaire comprend une gravure de la couche supplémentaire de sorte à diminuer localement son épaisseur, la couche isolante comportant des zones de surépaisseur de sorte que l'ensemble comprenant la couche supplémentaire et la couche isolante superposées soit d'épaisseur constante.

Selon un mode de réalisation non limitatif, le procédé comporte une étape de formation de la couche isolante comportant une application, une irradiation et un développement d'une résine photosensible, par exemple une résine SU8, sur la couche supplémentaire, de sorte à former un orifice supplémentaire, l'orifice supplémentaire étant placé en regard du motif supplémentaire lorsque la couche isolante et la couche supplémentaire sont superposées.

Selon un mode de réalisation non limitatif, le volume est constitué en partie d'un deuxième matériau, autre que le matériau de base, tel que le deuxième matériau remplit l'espace interne à la coque en métal ou en alliage métallique.

Selon un mode de réalisation non limitatif, le procédé comporte une étape de découpe de la zone latérale, réalisée avant l'étape de recouvrement.

### Description sommaire des dessins

D'autres particularités et avantages ressortiront clairement de la description qui en est faite ci-après, à titre indicatif et nullement limitatif, en référence aux dessins annexés, dans lesquels :
- la figure 1 est une représentation schématique d'une couche de base utilisée au sein d'un procédé selon un mode de réalisation non limitatif de l'invention, le procédé permettant de réaliser une pièce dotée d'au moins un élément d'habillage multi-niveaux
- la figure 2 est une représentation schématique d'une couche intermédiaire utilisée au sein du procédé
- la figure 3 est une représentation schématique d'une couche supplémentaire et d'une couche électriquement isolante, lesdites couches étant utilisées au sein du procédé
- la figure 4 représente une étape de superposition des couches des figures 1, 2 et 3, selon le procédé
- la figure 5 représente une étape de dépôt galvanique d'une couche métallique ou d'alliage selon le procédé
- la figure 6 représente une étape de recouvrement ou d'incrustation de la couche métallique ou d'alliage par un volume d'un matériau de base de la pièce selon le procédé
- la figure 7 représente la pièce finale obtenue par le procédé, la pièce étant dotée de deux éléments d'habillage multi-niveaux.

### Description détaillée des modes de réalisation préférés

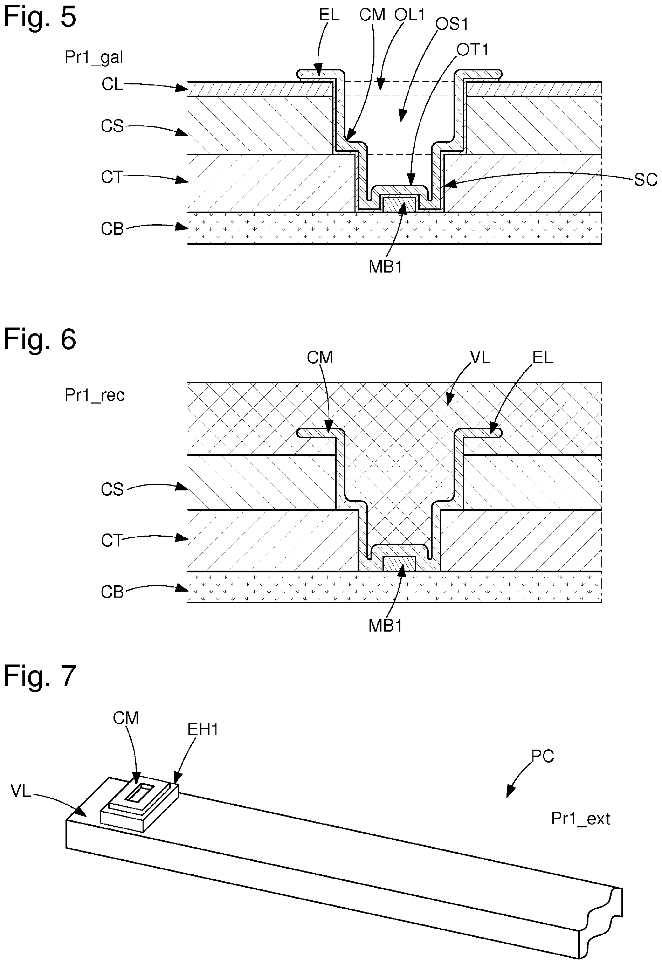

La présente description porte sur un procédé de fabrication Pr1 dont la mise en oeuvre combinée permet de fabriquer une pièce PC d'horlogerie dotée d'un élément d'habillage EH1 multi-niveaux telle que celle représentée à la figure 7. Le procédé Pr1 pourrait s'appliquer à toutes sortes de pièces, par exemple une pièce de joaillerie ou de bijouterie, ou une pièce d'outillage, et toutes sortes d'éléments d'habillage multi-niveaux. Enfin, la pièce pourrait naturellement comporter plus d'un élément d'habillage.

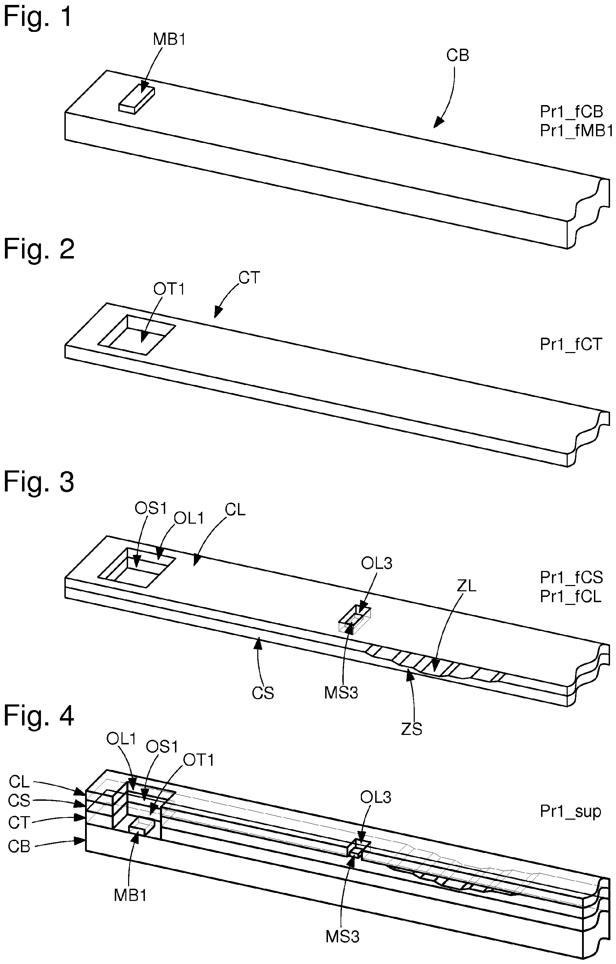

Les figures 1 à 3 montrent quatre couches CB, CT, CS et CL, qui sont ensuite superposées les unes aux autres lors d'une étape de superposition du procédé de fabrication. Chacune des couches CB, CT, CS et CL est métallique, ou en alliage métallique, ou minérale. Cependant, si une couche est minérale, certaines de ses zones doivent être rendues électriquement conductrices, par exemple par une technique de dépôt physique en phase vapeur (ou PVD pour l'anglais « Physical Vapor Déposition »), comme cela est expliqué dans la suite de la description.

La figure 1 montre une couche de base CB surmontée d'un motif de base MB1. L'ensemble CB/MB1 a été obtenu par une étape de formation Pr1_fCB de la couche de base CB suivie d'une étape de formation Pr1_fMB1 du motif de base MB1 selon le procédé Pr1. Dans un mode de réalisation non limitatif de l'étape Pr1_fCB, la couche de base CB est formée d'un substrat, par exemple un wafer en silicium. Dans un mode de réalisation non limitatif, on revêt ledit substrat d'un film électriquement conducteur par PVD. Cette étape n'est pas obligatoire, comme cela est expliqué dans la suite du texte, certaines parties de la couche de base CB peuvent être rendues conductrices dans une étape ultérieure du procédé, par un procédé tel que le PVD ou par contact avec une couche conductrice. Dans un mode de réalisation non limitatif de l'étape Pr1_fMB1, le motif de base MB1 est formé par :
- application d'une résine photosensible sur la couche de base CB, par exemple une résine de type SU-8
- irradiation de la résine à travers un photomasque correspondant à la forme souhaitée du motif de base MB1, par rayons ultra-violets dans le cas d'une résine SU-8, pour polymériser une zone de la résine correspondant au motif de base MB1
- développement de la résine, pour dissoudre les zones non polymérisées et faire apparaître le motif de base MB1.

Dans un autre mode de réalisation non limitatif de l'étape Pr1_fMB1, le motif de base MB1 est formé par dépôt d'une couche uniforme (de vernis ou autre) qui est ensuite sélectivement ablatée par laser

La figure 2 montre une couche intermédiaire CT comprenant un premier trou OT1 traversant. Dans un mode de réalisation non limitatif de l'étape Pr1_fCT, la couche intermédiaire CT est formée d'une plaque en alliage métallique, par exemple en laiton, que l'on découpe, par exemple au laser, pour obtenir le premier trou OT1. On note que le premier trou OT1 est de dimensions inférieures à la première ouverture OS1 de la figure 3.

La figure 3 montre une couche supplémentaire CS comprenant une première ouverture OS1 traversante, un motif supplémentaire MS3, et des zones d'épaisseur réduite ZS. La couche supplémentaire CS est superposée à une couche électriquement isolante CL comprenant un premier orifice OL1, un orifice supplémentaire OL3 et des zones de surépaisseur ZL. On note que les zones d'épaisseur réduite ZS de la couche supplémentaire CS pourraient alternativement être des zones de surépaisseur. Dans ce cas, les zones de surépaisseur ZL seraient des zones d'épaisseur réduite.

La couche supplémentaire CS a été obtenue par une étape de formation Pr1_fCS de ladite couche selon le procédé Pr1. Dans un mode de réalisation non limitatif de l'étape Pr1_fCS, la couche supplémentaire CS est formée d'une plaque en alliage métallique, par exemple en laiton, que l'on découpe, par exemple au laser, pour obtenir la première ouverture OS1. On note que dans un mode de réalisation non limitatif de l'étape Pr1_fCS, la plaque est préalablement texturée, par exemple guillochée ou brossée. En outre, dans un mode de réalisation non limitatif de l'étape Pr1_fCS, la couche supplémentaire CS est estampillée de sorte à créer une empreinte formant un motif supplémentaire MS3 tel que celui visible à la figure 3. Par ailleurs, dans un mode de réalisation non limitatif de l'étape Pr1_fCS, des zones ZS de la couche supplémentaire CS sont gravées, de manière à diminuer leur épaisseur, comme cela est représenté à la figure 3. Naturellement, toutes ces sous-étapes de l'étape Pr1_fCS ne sont pas obligatoires, seules certaines d'entre elles peuvent être réalisées.

La couche isolante CL a été obtenue par une étape de formation Pr1_fCL de ladite couche selon le procédé. Dans un mode de réalisation non limitatif de l'étape Pr1_fCL, la couche isolante CL est obtenue par :
- application d'une résine photosensible sur la couche supplémentaire CS, par exemple une résine de type SU-8. On note que la résine présente alors des zones de surépaisseur ZL au niveau des zones d'épaisseur réduite de la couche supplémentaire CS, ou inversement si la couche supplémentaire CS comporte des zones de surépaisseur.
- irradiation de la résine à travers un photomasque, par rayons ultra-violets dans le cas d'une résine SU-8, pour polymériser la résine à l'exception des zones en regard de la première ouverture OS1 et du motif supplémentaire MS3
- développement de la résine, pour dissoudre les zones non polymérisées et faire apparaître un premier orifice OL1 superposé à la première ouverture OS1, et un orifice supplémentaire OL3 en regard du motif supplémentaire MS3.

La figure 4 montre les quatre couches superposées à l'issue d'une étape de superposition Pr1_sup, du procédé Pr1. Plus précisément, la couche isolante CL est superposée à la couche supplémentaire CS, elle-même superposée à la couche intermédiaire CT, elle-même superposée à la couche de base CB. Les différents orifices, ouvertures, trous et motifs sont tels que :
- le motif de base MB1 est positionné dans le premier trou OT1, le premier trou OT1 est recouvert par la première ouverture OS1, et le premier orifice OL1 est superposé à la première ouverture OS1
- le motif supplémentaire MS3 est positionné en regard de l'orifice supplémentaire OL3.

Puis, dans une étape non représentée, des parois SC (visibles à la figure 5) du motif de base MB1, du premier orifice OL1, de la première ouverture OS1, du premier trou OT1, et des parois exposées de la couche de base CB sont rendues conductrices, par exemple par dépôt PVD d'un film conducteur. Naturellement, le dépôt PVD du film conducteur n'est nécessaire que sur les faces non initialement conductrices. Ainsi, dans un mode de réalisation alternatif, seules certaines des parois précitées subissent un dépôt PVD ou tout autre traitement équivalent dans le but de les rendre conductrices. Lors de cette étape, une portion SCL de la face supérieure de la couche isolante CL (c'est-à-dire la face non en contact avec la couche supérieure CS) en périphérie du premier orifice OL1 peut également être rendue conductrice.

Il en est de même pour des parois du motif supplémentaire MS3, de l'orifice supplémentaire OL3, et des parois exposées de la couche supplémentaire CS. De même, une portion de la face supérieure de la couche isolante CL en périphérie de l'orifice supplémentaire OL3 peut également être rendue conductrice.

La figure 5 représente schématiquement une étape de dépôt galvanique Pr1_gal d'une couche métallique ou d'alliage CM sur les faces internes du premier orifice OL1, de la première ouverture OS1, du premier trou OT1, sur les faces du motif de base MB et sur les faces exposées de la couche de base CB, selon le procédé Pr1. Ainsi, les quatre couches CB, CT, CS et CL superposées sont plongées dans un bain galvanique adapté à la déposition d'un métal tel que l'or, l'argent, le nickel, ou tout autre métal ou alliage métallique pouvant se déposer en couche relativement épaisse, pour y subir un électroformage. L'électroformage s'achève lorsque les parois précitées sont complètement recouvertes de la couche métallique ou d'alliage CM et que l'épaisseur de la coque obtenue est jugée suffisante. La couche métallique ou d'alliage CM comporte alors une zone latérale EL qui repose sur la couche isolante CL. Dans le cas où la portion SCL de la face supérieure de la couche isolante CL en périphérie du premier orifice OL1 a été rendue conductrice, la zone latérale EL s'étend au moins en partie sur ladite portion SCL.

De même, une couche métallique ou d'alliage est déposée de manière similaire sur les parois de l'orifice supplémentaire OL3, du motif supplémentaire MS3 et sur les parois exposées de la couche supplémentaire CS. Dans le cas où une portion de la face supérieure de la couche isolante CL en périphérie de l'orifice supplémentaire OL3 a été rendue conductrice, la zone latérale EL s'étend au moins en partie sur ladite portion.

La couche métallique ou d'alliage CM forme une coque d'une certaine épaisseur. Puis, dans une étape non représentée, on dissout la couche isolante CL par passage dans des bains adaptés. La zone latérale EL est alors éventuellement découpée, en fonction du type de pièce à réaliser. Découper la zone latérale EL est intéressant si la pièce à fabriquer est un outillage de type poinçon par exemple.

La figure 6 représente schématiquement une étape de recouvrement ou d'incrustation Pr1_rec de la couche supplémentaire CS et de la couche métallique ou d'alliage CM, par un volume VL d'un matériau de base de la pièce à fabriquer, selon le procédé Pr1. Dans un mode de réalisation, le matériau de base est du métal amorphe ou partiellement amorphe, intéressant pour ses propriétés mécaniques. Dans un autre mode de réalisation, le matériau de base est un polymère ou un composite (céramique polymère, composite fibre de carbone, etc.). Dans ces deux cas, un bloc de métal ou d'alliage métallique ou d'alliage amorphe ou partiellement amorphe, ou de polymère ou composite, est pressé sur la couche supplémentaire CS et contre la couche métallique ou d'alliage CM à une température à laquelle il a une consistance pâteuse. Ceci lui permet de se déformer pour épouser les formes de la couche métallique ou d'alliage CM, et notamment les formes de la zone latérale EL de la couche métallique ou d'alliage CM si celles-ci n'ont pas été préalablement découpées. Alternativement, le matériau de base peut être coulé. Dans un autre mode de réalisation, le matériau de base est tout autre métal ou alliage métallique, par exemple du nickel, de l'or, etc., et le recouvrement est réalisé par croissance galvanique dudit métal. On remarque, dans le cas où la zone latérale EL n'a pas été préalablement découpée, qu'à l'issue de l'étape Pr1_rec, la couche métallique ou d'alliage CM est solidarisée avec le volume VL de matériau de base, car la zone latérale EL est scellée dans le volume VL de matériau de base. Bien que cela ne soit pas représenté, les couches métalliques ou d'alliages (au niveau du motif supplémentaire MS3) sont recouvertes et scellées dans le volume VL de manière similaire.

Dans un mode de réalisation alternatif de l'étape de recouvrement/d'incrustation Pr1_rec, le volume VL n'est pas intégralement constitué du matériau de base de la pièce. Dans ce cas, une partie seulement du volume est constituée du matériau de base de la pièce, tandis que l'autre partie est constituée d'un deuxième matériau, avantageusement moins cher que le matériau de base. La partie du volume VL constituée du deuxième matériau remplit ainsi avantageusement l'espace interne à la coque en métal en alliage, tandis que les parties du volume VL constituées du matériau de base sont situées aux endroits visibles, externes, de la pièce.

La figure 7 représente schématiquement une étape d'extraction Pr1_ext, du volume VL et des couches métalliques ou d'alliages CM, selon le procédé Pr1. En d'autres termes, le volume VL et les couches métalliques ou d'alliages CM sont séparées de la couche supplémentaire CS, de la couche intermédiaire CT et de la couche de base CB. Pour ce faire, l'ensemble est par exemple plongé dans un bain acide sélectif au sein duquel la couche supplémentaire CS, la couche intermédiaire CT et la couche de base CB sont dissoutes. Alternativement, la séparation est réalisée par démoulage en force. On note qu'avoir préalablement réalisé un traitement de surface de la couche supplémentaire CS permet de faciliter le démoulage. Ce traitement est par exemple l'application d'un agent de démoulage ou un traitement de passivation.

Le volume VL forme alors le corps de la pièce PC, et les couches métalliques ou d'alliages CM forment l'élément d'habillage EH1 (l'élément d'habillage supplémentaire, résultant de la duplication du motif supplémentaire MS3, n'est pas représenté sur la figure 7). On comprend donc que les formes et dimensions des éléments d'habillage sont directement dépendantes des formes et dimensions des motifs, ainsi que des formes et dimensions des divers orifices, ouvertures et trous mis en jeu lors des procédés.

Grâce aux procédés décrits, le désengagement des éléments d'habillage du volume de matériau de base est impossible sans détruire la pièce. De plus, on note que les interfaces entre le corps de pièce et les éléments d'habillage sont nettes. Par ailleurs, par un effet d'empreinte de la texture de la couche supplémentaire sur le volume se produisant lors de l'étape de recouvrement, le corps de pièce est texturé.

Bien entendu, la présente invention ne se limite pas à l'exemple illustré mais est susceptible de diverses variantes et modifications qui apparaîtront à l'homme de l'art, en particulier en ce qui concerne le nombre des couches superposées, les formes et dimensions des différents orifices, ouvertures, trous, motifs, etc.

## Revendications

1. Procédé (Pr1) de fabrication d'une pièce (PC) dotée d'un élément d'habillage (EH1), comportant les étapes suivantes, dans cet ordre :
- Superposer (Pr1_sup) une couche électriquement isolante (CL) comportant un premier orifice (OL1) traversant, une couche supplémentaire (CS) comportant une première ouverture (OS1) traversante de dimensions similaires au premier orifice (OL1), une couche intermédiaire (CT) comprenant un premier trou (OT1) traversant, et une couche de base (CB) surmontée d'un motif de base (MB1), de sorte à placer le motif de base (MB1) dans le premier trou (OT1), recouvrir le premier trou (OT1) par la première ouverture (OS1), et superposer la première ouverture (OS1) et le premier orifice (OL1)
- Déposer (Pr1_gal) galvaniquement une couche métallique ou d'alliage métallique (CM), de sorte qu'à l'issue de cette étape, la couche métallique ou d'alliage métallique (CM) forme une coque recouvrant des parois électriquement conductrices du motif de base (MB1), du premier orifice (OL1), de la première ouverture (OS1) et du premier trou (OT1), et comporte une zone latérale (EL) reposant sur la couche isolante (CL)
- Dissoudre la couche isolante (CL)
- Recouvrir (Pr1_rec) la couche métallique ou d'alliage métallique (CM) d'un volume (VL) constitué au moins en partie par un matériau de base de la pièce (PC), de sorte que le volume (VL) épouse les formes de la couche métallique ou d'alliage métallique (CM)
- Extraire (Pr1_ext) le volume (VL) et la couche métallique ou d'alliage métallique (CM).

2. Procédé (Pr1) selon la revendication précédente, comportant une étape de formation de surfaces électriquement conductrices (SC) sur les parois du motif de base (MB1), du premier orifice (OL1), de la première ouverture (OS1) et/ou du premier trou (OT1), par exemple par une technique de dépôt physique par phase vapeur.

3. Procédé (Pr1) selon la revendication précédente, comportant une étape de formation d'une surface électriquement conductrice (SCL) sur une portion d'une face supérieure de la couche isolante (CL) située en périphérie du premier orifice (OL1).

4. Procédé (Pr1) selon l'une des revendications précédentes, comprenant une étape de formation (Pr1_fMB1) du motif de base (MB1) sur la couche de base (CB), comportant une application, une irradiation et un développement d'une résine photosensible, par exemple une résine SU8.

5. Procédé (Pr1) selon l'une des revendications précédentes, comprenant une étape de formation (Pr1_fCB) de la couche de base (CB) à partir d'un wafer en silicium, comportant un revêtement dudit wafer par un film conducteur.

6. Procédé (Pr1) selon l'une des revendications précédentes, comprenant une étape de formation (Pr1_fCT) de la couche intermédiaire (CT) comportant une découpe, par exemple au laser, d'une plaque, par exemple en laiton.

7. Procédé (Pr1) selon l'une des revendications précédentes, comprenant une étape de formation (Pr1_fCS) de la couche supplémentaire (CS) comportant une découpe, par exemple au laser, d'une plaque, par exemple en laiton.

8. Procédé (Pr1) selon la revendication précédente, l'étape de formation (Pr1_fCS) de la couche supplémentaire (CS) comprenant un estampillage de la couche supplémentaire (CS) de sorte à y former un motif supplémentaire (MS3), la couche électriquement isolante (CL) comportant un orifice supplémentaire (OL3), l'orifice supplémentaire (OL3) étant placé en regard du motif supplémentaire (MS3) lorsque le couche isolante (CL) et la couche supplémentaire (CS) sont superposées.

9. Procédé (Pr1) selon l'une des revendications 7 ou 8, l'étape de formation (Pr1_fCS) de la couche supplémentaire (CS) comprenant une gravure de la couche supplémentaire (CS) de sorte à diminuer localement son épaisseur, la couche isolante (CL) comportant des zones de surépaisseur de sorte que l'ensemble comprenant la couche supplémentaire (CS) et la couche isolante (CL) superposées soit d'épaisseur constante.

10. Procédé (Pr1) selon l'une des revendications 8 ou 9, comprenant une étape de formation (Pr1_fCL) de la couche isolante (CL) comportant une application, une irradiation et un développement d'une résine photosensible, par exemple une résine SU8, sur la couche supplémentaire (CS), de sorte à former un orifice supplémentaire (OL3), l'orifice supplémentaire (OL3) étant placé en regard du motif supplémentaire (MS3) lorsque la couche isolante (CL) et la couche supplémentaire (CS) sont superposées.

11. Procédé (Pr1) selon l'une des revendications précédentes, **caractérisé en ce que** le volume (VL) est constitué en partie d'un deuxième matériau, autre que le matériau de base, tel que le deuxième matériau remplit l'espace interne à la coque en métal ou en alliage métallique.

## Patentansprüche

1. Verfahren (Pr1) für die Herstellung eines mit einem Verkleidungselement (EH1) versehenen Teils (PC), umfassend die folgenden Schritte in dieser Reihenfolge:
- Übereinanderlegen (Pr1_sup) einer elektrisch isolierenden Schicht (CL), die eine erste Durchgangsöffnung (OL1) aufweist, einer weiteren Schicht (CS), die ein erstes Durchgangsfenster (OS1) mit ähnlichen Abmessungen wie die erste Öffnung (OL1) aufweist, einer Zwischenschicht (CT), die ein erstes Durchgangsloch (OT1) aufweist, und einer Basisschicht (CB), auf der ein Grundmuster (MB1) aufgebracht ist, derart, dass das Grundmuster (MB1) in dem ersten Loch (OT1) angeordnet ist, das erste Loch (OT1) durch das erste Fenster (OS1) überdeckt ist und das erste Fenster (OS1) und die erste Öffnung (OL1) einander überlagert sind,
- galvanisches Ablagern (Pr1_gal) einer Metall- oder einer Metalllegierungsschicht (CM), so dass am Ende dieses Schrittes die Metall- oder die Metalllegierungsschicht (CM) eine Hülle bildet, die elektrisch leitende Wände des Grundmusters (MB1), der ersten Öffnung (OL1), des ersten Fensters (OS1) und des ersten Lochs (OT1) überdeckt und einen seitlichen Bereich (EL) aufweist, der auf der isolierenden Schicht (CL) aufliegt,
- Auflösen der isolierenden Schicht (CL),
- Überdecken (Pr1_rec) der Metall- oder der Metalllegierungsschicht (CM) mit einem Volumen (VL), das mindestens teilweise durch ein Basismaterial des Teils (PC) gebildet ist, derart, dass sich das Volumen (VL) an die Formen der Metall- oder der Metalllegierungsschicht (CM) anschmiegt,
- Entnehmen (Pr1_ext) des Volumens (VL) und der Metall- oder der Metalllegierungsschicht (CM).

2. Verfahren (Pr1) nach dem vorhergehenden Anspruch, umfassend einen Schritt zum Bilden elektrisch leitender Oberflächen (SC) auf den Wänden des Grundmusters (MB1), der ersten Öffnung (OL1), des ersten Fensters (OS1) und/oder des ersten Lochs (OT1), beispielsweise durch eine Technik der physikalischen Gasphasenabscheidung.

3. Verfahren (Pr1) nach dem vorhergehenden Anspruch, umfassend einen Schritt zum Bilden einer elektrisch leitenden Oberfläche (SCL) auf einem Abschnitt einer oberen Fläche der isolierenden Schicht (CL), der sich am Umfang der ersten Öffnung (OL1) befindet.

4. Verfahren (Pr1) nach einem der vorhergehenden Ansprüche, umfassend einen Schritt (Pr1_fMB1) zum Bilden des Grundmusters (MB1) auf der Basisschicht (CB), der das Aufbringen, Bestrahlen und Ausbilden eines lichtempfindlichen Harzes, beispielsweise eines Harzes SU8, umfasst.

5. Verfahren (Pr1) nach einem der vorhergehenden Ansprüche, umfassend einen Schritt (Pr1_fCB) zum Bilden der Basisschicht (CB) anhand eines Silicium-Wafers mit Beschichten des Wafers mit einem leitenden Film.

6. Verfahren (Pr1) nach einem der vorhergehenden Ansprüche, umfassend einen Schritt (Pr1_fCT) zum Bilden der Zwischenschicht (CT), der das Ausschneiden einer Platte, die beispielsweise aus Messing hergestellt ist, zum Beispiel mittels Laser umfasst.

7. Verfahren (Pr1) nach einem der vorhergehenden Ansprüche, umfassend einen Schritt (Pr1_fCS) zum Bilden der weiteren Schicht (CS), der das Ausschneiden einer Platte, die beispielsweise aus Messing hergestellt ist, zum Beispiel mittels Laser umfasst.

8. Verfahren (Pr1) nach dem vorhergehenden Anspruch, wobei der Schritt (Pr1_fCS) zum Bilden der weiteren Schicht (CS) das Prägen der weiteren Schicht (CS) umfasst, derart, dass darauf ein weiteres Muster (MS3) ausgebildet wird, wobei die elektrisch isolierende Schicht (CL) eine weitere Öffnung (OL3) aufweist, wobei die weitere Öffnung (OL3) gegenüber dem weiteren Muster (MS3) angeordnet ist, wenn die isolierende Schicht (CL) und die weitere Schicht (CS) einander überlagert sind.

9. Verfahren (Pr1) nach einem der Ansprüche 7 oder 8, wobei der Schritt (Pr1_fCS) zum Bilden der weiteren Schicht (CS) das Ätzen der weiteren Schicht (CS) umfasst, derart, dass ihre Dicke lokal verringert wird, wobei die isolierende Schicht (CL) Bereiche mit Überdicke aufweist, so dass die Anordnung, die die weitere Schicht (CS) und die isolierende Schicht (CL), die einander überlagert sind, umfasst, eine konstante Dicke besitzt.

10. Verfahren (Pr1) nach einem der Ansprüche 8 oder 9, umfassend einen Schritt (Pr1_fCL) zum Bilden der isolierenden Schicht (CL), der das Aufbringen, Bestrahlen und Ausbilden eines lichtempfindlichen Harzes, beispielsweise eines Harzes SU8, auf der weiteren Schicht (CS) umfasst, derart, dass eine weitere Öffnung (OL3) gebildet wird, wobei die weitere Öffnung (OL3) gegenüber dem weiteren Muster (MS3) angeordnet ist, wenn die isolierende Schicht (CL) und die weitere Schicht (CS) einander überlagert sind.

11. Verfahren (Pr1) nach einem der vorhergehenden Ansprüche, **dadurch gekennzeichnet, dass** das Volumen (VL) teilweise aus einem zweiten Material, das von dem Basismaterial verschieden ist, gebildet ist, derart, dass das zweite Material den inneren Raum der Hülle aus Metall oder einer Metalllegierung füllt.

## Claims

1. Method (Pr1) for fabrication of a piece (PC) provided with an exterior element (EH1), comprising the following ordered steps:
- Superposing (Pr1_sup) an electrically insulating layer (CL) including a first through orifice (OL1), an additional layer (CS) including a first through aperture (OS1) of similar dimensions to the first orifice (OL1), an intermediate layer (CT) including a first through hole (OT1), and a base layer (CB) surmounted by a base motif (MB1), so as to place the base motif (MB1) inside the first hole (OT1), cover the first hole (OT1) with the first aperture (OS1), and superpose the first aperture (OS1) and the first orifice (OL1)
- Electrodepositing (Pr1_gal) a metal or metal alloy layer (CM), so that at the end of this step, the metal or metal alloy layer (CM) forms a shell covering electrically conductive walls of the base motif (MB1), of the first orifice (OL1), of the first aperture (OS1) and of the first hole (OT1), and comprises a lateral area (EL) resting on the insulating layer (CL)
- Dissolving the insulating layer (CL)
- Coating (Pr1_rec) the metal or metal alloy layer (CM) with a volume (VL) at least partly formed by a base material of the piece (PC), so that the volume (VL) conforms to the shapes of the metal or metal alloy layer (CM)
- Removing (Pr1_ext) the volume (VL) and the metal or metal alloy layer (CM).

2. Method (Pr1) according to the preceding claim, including a step of forming electrically conductive surfaces (SC) on the walls of the base motif (MB1), of the first orifice (OL1), of the first aperture (OS1) and/or of the first hole (OT1), for example by a physical vapour deposition technique.

3. Method (Pr1) according to the preceding claim, including a step of forming an electrically conductive surface (SCL) on one portion of an upper face of the insulating layer (CL) located at the periphery of the first orifice (OL1).

4. Method (Pr1) according to any of the preceding claims, including a step (Pr1_fMB1) of forming the base motif (MB1) on the base layer (CB), including an application, irradiation and development of a photosensitive resin, for example an SU-8 resin.

5. Method (Pr1) according to any of the preceding claims, including a step (Pr1_fCB) of forming the base layer (CB) from a silicon wafer, including coating said wafer with a conductive film.

6. Method (Pr1) according to any of the preceding claims, including a step (Pr1_fCT) of forming the intermediate layer (CT) including cutting, for example laser cutting, of a plate, for example made of brass.

7. Method (Pr1) according to any of the preceding claims, including a step (Pr1_fCS) of forming the additional layer (CS) including cutting, for example laser cutting, of a plate, for example made of brass.

8. Method (Pr1) according to the preceding claim, the step (Pr1_fCS) of forming the additional layer (CS) including stamping the additional layer (CS) so as to form therein an additional motif (MS3), the electrically insulating layer (CL) including a third orifice (OL3), the third orifice (OL3) being placed facing the additional motif (MS3) when the insulating layer (CL) and the additional layer (CS) are superposed.

9. Method (Pr1) according to any of claims 7 or 8, the step (Pr1_fCS) of forming the additional layer (CS) including an etch of the additional layer (CS) to locally diminish the thickness thereof, the insulating layer (CL) including areas of excess thickness so that the assembly comprising the superposed additional layer (CS) and insulating layer (CL) is of constant thickness.

10. Method (Pr1) according to any of claims 8 or 9, including a step (Pr1_fCL) of forming the insulating layer (CL) including an application, irradiation and development of a photosensitive resin, for example an SU-8 resin, on the additional layer (CS), so as to form a third orifice (OL3), the third orifice (OL3) being placed facing the additional motif (MS3) when the insulating layer (CL) and the additional layer (CS) are superposed.

11. Method (Pr1) according to any of the preceding claims, characterized the volume (VL) is partly formed of a second material, different from the base material, so that the second material fills the space inside the metal or metal alloy shell.
